(19) Europäisches Patentamt
European Patent Office
Office européen des brevets

(11) **EP 3 667 718 B1**

(12) **EUROPEAN PATENT SPECIFICATION**

(45) Date of publication and mention
of the grant of the patent:
**22.12.2021 Bulletin 2021/51**

(21) Application number: **18844599.3**

(22) Date of filing: **06.08.2018**

(51) Int Cl.:
*C08J 5/18* (2006.01)       *C08K 3/22* (2006.01)
*C08K 3/38* (2006.01)       *H01L 23/373* (2006.01)
*B32B 5/02* (2006.01)       *B32B 27/20* (2006.01)
*B32B 27/28* (2006.01)       *C08L 83/04* (2006.01)

(86) International application number:
**PCT/JP2018/029456**

(87) International publication number:
**WO 2019/031458 (14.02.2019 Gazette 2019/07)**

(54) **LOW-DIELECTRIC-CONSTANT THERMALLY-CONDUCTIVE HEAT DISSIPATION MEMBER**

WÄRMELEITENDES WÄRMEABLEITUNGSELEMENT MIT NIEDRIGER DIELEKTRIZITÄTSKONSTANTE

ÉLÉMENT DE DISSIPATION DE CHALEUR THERMOCONDUCTEUR À FAIBLE CONSTANTE DIÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.08.2017 JP 2017155535**

(43) Date of publication of application:
**17.06.2020 Bulletin 2020/25**

(73) Proprietor: **Denka Company Limited
Tokyo 103-8338 (JP)**

(72) Inventors:
• **YAMAGATA, Toshitaka
Omuta-city
Fukuoka 836-8510 (JP)**
• **WADA, Kosuke
Omuta-city
Fukuoka 836-8510 (JP)**
• **KANEKO, Masahide
Omuta-city
Fukuoka 836-8510 (JP)**

(74) Representative: **Gulde & Partner
Patent- und Rechtsanwaltskanzlei mbB
Wallstraße 58/59
10179 Berlin (DE)**

(56) References cited:
JP-A- H1 126 661       JP-A- 2011 144 234
JP-A- 2011 184 507     JP-A- 2014 172 768

**Description**

Technical Field

The present invention relates to a heat-dissipating member having a low dielectric constant and excellent thermal conductivity, and applications of the heat-dissipating member.

Background Art

In heat-releasing electronic components such as power devices, transistors, thyristors and CPUs, it is a matter of importance is how to remove heat generated during the operation of the electronic components. In a conventional manner, as such a heat-removal method, heat is typically released by attaching the heat-releasing electronic component to heat-dissipating fins or a metallic plate through a heat dissipating sheet having electrical insulation properties, and the heat dissipating sheet is obtained by dispersing a thermally conductive filler in a silicone rubber is employed.

In recent years, with a higher degree of the integration of a circuit in an electronic component, the amount of heat generated in the circuit has become larger, and a material having higher thermal conductivity than conventionally has been demanded. Such a material is also demanded to have electrical insulation properties, and required to be resistant to the flow of electric current and be a low-dielectric-constant material. Up to now, for the purpose of improving the thermal conductivity of the thermally conductive material, it has been typical to incorporate a filler exhibiting high thermal conductivity such as an aluminum oxide powder, a boron nitride powder and an aluminum nitride powder in an organic resin. Also, a hexagonal boron nitride powder in the form of scale having poor loading ability has been subjected to a method by which the hexagonal boron nitride powder as secondary agglomerated particles is loaded into an organic resin to provide high thermal conductivity (Patent Literatures 1 to 4). The orientation of the hexagonal boron nitride powder is described in Patent Literatures 5 and 6, or the like.

In Patent Literature 7, it is described that a resin composition containing an agglomerated powder of hexagonal boron nitride having predetermined physical properties, and an aluminum oxide powder possesses excellent thermal conductivity.

In Patent Literature 8 heat radiating members are described.

Citation List

Patent Literature

Patent Literature 1: JP 11-060216 A
Patent Literature 2: JP 2003-060134 A
Patent Literature 3: JP 2008-293911 A
Patent Literature 4: JP 2009-024126 A
Patent Literature 5: JP 09-202663 A
Patent Literature 6: JP 11-026661 A
Patent Literature 7: JP 2011-144234 A
Patent Literature 8: JP 2014-172768 A

Summary of Invention

Technical Problem

However, an apparatus subjected to the incorporation of electronic components is increasingly downsized or becomes thinner, restrictions regarding a region occupied by the heat-dissipating member becomes stricter. Therefore, in the above conventional technologies, the following problem has not been solved: the heat-dissipating member having such a restricted size is difficult to have both of the satisfactory thermal conductivity (heat dissipation) and the insulation properties (dielectric properties).

Solution to Problem

It is an object of the present invention to provide a heat-dissipating member having both of excellent thermal conductivity and excellent dielectric properties, and allowed for use in a small or thin apparatus. For the purpose of solving the above problem, embodiments of the present invention may provide the following.

A heat-dissipating member in the form of a sheet having a thickness of 0.1 to 0.5 mm and comprising a resin composition, wherein

the resin composition contains

60 to 70% by volume of a thermally conductive filler including an agglomerated powder of hexagonal boron nitride having an average particle size of 10 to 20 μm and an orientation index defined below of 2 to 20, and an aluminum oxide powder having an average particle size of 3 to 7 μm, and
30 to 40% by volume of a silicone resin, and

the orientation index is a ratio (I002/I100) of an intensity I002 of a diffraction line on a (002) plane to an intensity I100 of a diffraction line on a (100) plane according to X-ray powder diffraction, and
the blending ratio between hexagonal boron nitride and aluminum oxide in the thermally conductive filler is in the range of 4:1 to 1:1 in terms of a volume ratio.

A heat-dissipating member, wherein a heat-dissipating member as described above is laminated on a glass cloth.

Advantageous Effects of Invention

According to the present invention, it is possible to provide a resin composition having a low dielectric constant and exhibiting high thermal conductivity.

Description of Embodiments

Hereinbelow, the present invention will be described in a detailed manner. Unless otherwise stated, numerical ranges shown in the present specification include both of the lower limit value and the upper limit value.

The agglomerated powder of hexagonal boron nitride for use in the thermally conductive filler according to an embodiment of the present invention is required to have an average particle size of 10 to 20 μm, and in addition, the average particle size is preferably in the range of 12 to 18 μm. When the average particle size is greater than 20 μm, the gap between particles upon contact with each other is large, and the thermal conductivity tends to decrease. In contrast to this, when the average particle size is less than 10 μm, the loading ability of the thermally conductive material is impaired, the thermal conductivity tends to decrease.

Hexagonal boron nitride is typically in the form of scale or polygonal plate, and the agglomerated powder of hexagonal boron nitride is a powder obtained by assembling and clumping primary particles of hexagonal boron nitride together. The agglomeration state of hexagonal boron nitride may be evaluated by an orientation index according to X-ray powder diffraction. The orientation index is a ratio (I002/I100) of an intensity I002 of a diffraction line on a (002) plane to an intensity I100 of a diffraction line on a (100) plane according to X-ray powder diffraction. In the hexagonal boron nitride powder, I002 is typically greater than or equal to I100, and therefore, the orientation index is 1 or more. As the orientation index becomes lower, the non-orientation properties are exhibited to a larger extent, and when the orientation index is 1, entire non-orientation is brought about. As the orientation becomes larger, the orientation index becomes higher. The orientation index of the agglomerated powder of hexagonal boron nitride according to the present invention is 2 to 20, and preferably 2 to 10. When the orientation index is greater than 20, the thermal conductivity tends to decrease. The orientation index of the agglomerated powder of hexagonal boron nitride may be adjusted by treating primary particles of hexagonal boron nitride with a binder, or subjecting the primary particles to heat treatment.

The aluminum oxide powder for use in the thermally conductive filler according to an embodiment of the present invention is required to have an average particle size of 3 to 7 μm, and in addition, the average particle size is preferably in the range of 4 to 6 μm. When an aluminum oxide powder is not loaded as the thermally conductive filler, and the agglomerated powder of boron nitride described above is solely used as the thermally conductive filler, voids tend to be present between the agglomerated powders, and the resin composition is difficult to be obtained, and in addition, the thermal conductivity tends to decrease. When the average particle size is greater than 7 μm, the number of the aluminum oxide particles to be in contact with a powder agglomerate of boron nitride decreases, and the thermal conductivity tends to decrease. In contrast to this, when the average particle size is less than 3 μm, the loading ability of the aluminum oxide powder is impaired, and the thermal conductivity tends to decrease.

The blending ratio between hexagonal boron nitride and aluminum oxide is in the range of 4:1 to 1:1, and preferably in the range of 3:2 to 1:1 in terms of a volume ratio.

Moreover, in a certain embodiment, an electrically conductive powder of aluminum, copper, silver, carbon fibers, carbon nanotubes or the like may be included in the thermally conductive filler, as long as the heat dissipation is not impaired.

The content of the thermally conductive filler in the resin composition according to an embodiment of the present invention is 60 to 70% by volume based on the total volume, and in particular, this content is desirably 62 to 68% by volume. When the content of the thermally conductive filler is less than 60% by volume, the thermal conductivity of the resin composition is unsatisfactory, and when this content is greater than 70% by volume, it is difficult to load the thermally conductive filler.

The average particle size in the present specification may be determined by using an apparatus for measuring particle size distribution using laser diffraction such as "an apparatus for measuring particle size distribution using laser diffraction, SALD-200" manufactured by Shimadzu Corporation. In an apparatus for measuring particle size distribution using laser diffraction, the particle size distribution is calculated from data of the light intensity distribution regarding the diffraction/scattered light due to the particles detected by a sensor. The average particle size is determined by multiplying the measured value of the particle size by the relative amount of the particles (%difference), and dividing the resulting value by the total relative amount of the particles (100%). The average particle size is the average diameter of the particle.

A millable silicone is representative of the silicone resin, which is an organic resin for use as a matrix (base material) of the resin composition in the present heat-dissipating member; however, in general, the required flexibility is often difficult to be achieved, and therefore, the silicone of addition reaction type is preferable for the purpose of achieving high flexibility. Specific examples of the liquid silicone of addition reaction type include an organopolysiloxane of one-part reaction type having both of a vinyl group and a H-Si group in a single molecule, or a two-part silicone made of an organopolysiloxane having a vinyl group located at the end or the side chain, and of an organopolysiloxane having two or more H-Si groups located at the end or the side chain. Examples of commercially available liquid silicones of addition reaction type include trade name "ELASTOSIL LR3303/20A/B" manufactured by Wacker Asahikasei Silicone Co., Ltd.

The sheet thickness of the heat-dissipating member according to the present invention is 0.1 to 0.5 mm, and in particular, is desirably 0.2 mm to 0.3 mm. When the sheet thickness is less than 0.1 mm, the thermally conductive filler appears on a surface of the sheet, and as a result of this, depressions and projections occur, and the thermal conductivity is impaired. When the sheet thickness is greater than 0.5 mm, the distance of heat transfer in the sheet is long, and the thermal conductivity decreases.

The thermal conductivity of the present heat-dissipating member is desirably 6W/ (m·K) or more. When the thermal conductivity is less than 6W/ (m·K), the heat dissipation from the heat-releasing component decreases.

The dielectric constant of the present heat-dissipating member is desirably 4 or less. When the dielectric constant is greater than 4, the insulation properties between the heat-releasing component and the cooler decrease.

Examples of the silicone of addition reaction type include organopolysiloxanes having a vinyl group, and organopolysiloxanes having a H-Si group, and the silicone of addition reaction type is further heated by using a platinum compound as a catalyst to proceed the curing reaction, and as a result of this, a cured resin product is obtained.

The liquid silicone of addition reaction type may be used in combination with reaction retarding agents such as acetyl alcohols or maleic acid esters, thickening agents such as Aerosil or a silicone powder having a size of tens to hundreds of micrometers, flame retardants, pigments, and the like.

In the preferable embodiment, the present heat-dissipating member may further include a glass cloth as a reinforcing material. Examples of the glass cloth include gray cloth purely made of woven glass fibers, and cloths subjected to a certain treatment such as one subjected to heat cleaning or treatment with a coupling agent. Examples of commercially available glass cloth include trade name "H25 F104" manufactured by Unitika Ltd.

It is possible to select any process for producing the resin composition. For example, an agglomerated powder of a boron nitride powder and an aluminum oxide powder were added to liquid silicone of addition reaction type, and mixed together by using a planetary centrifugal mixer, "Awatori Rentaro" manufactured by Thinky Corporation, and as a result of this, a resin composition may be produced without the disintegration of the agglomerated powder of the boron nitride powder.

Example

Sheet-formed articles were product to evaluate the thermal conductivity and the insulation properties of the heat-dissipating members according to Examples and Comparative Examples described below. A plunger extruder was used to produce a sheet-formed article without the disintegration of the agglomerated powder of the boron nitride powder. The sheet-formed articles for the evaluation of the thermal conductivity were worked into the respective thickness shown in the following Tables 2 and 3, and the size of the sheet-formed articles was 10 mm × 10 mm. The sheet-formed articles for the evaluation of insulation properties were separately provided and worked into the respective thickness shown in Tables 2 and 3, and the size of the sheet-formed articles was 100 mm × 100 mm.

The thermal conductivity was calculated by multiplying all of the thermal diffusivity, the density and the specific heat of the resin composition according to ASTM E-1461 (thermal conductivity = thermal diffusivity × density × specific heat). The sample was worked into a width of 10 mm × 10 mm × a thickness of 1 mm to determine the thermal diffusivity by a laser flash method. As the measurement apparatus, a xenon flash analyzer (LFA447 NanoFlash manufactured by NETSCH) was employed, and the measurement was performed at 25°C. The density was determined according to the Archimedes method. The specific heat was determined by using DSC (ThermoPlus Evo DSC8230 manufactured by Rigaku Corporation).

The dielectric constant indicative of insulation properties was measured by a method based on a general test method for thermosetting plastic according to JIS-K6911:2006 with the aid of model HP E5050A manufactured by Hewlett-Packard Company. The measurement was performed at a frequency of 1 MHz with the sample being sandwiched to determine the dielectric constant.

The agglomerated powder of hexagonal boron nitride was formed into a sample plate, and the sample plate was subjected to the measurement in the range of $2\theta = 30°$ to $25°$ by using an X-ray diffraction apparatus ("model Geiger Flex 2013" manufactured by Rigaku Denki Co., Ltd.) to determine the intensity 1002 of the diffraction line around $2\theta = 27$ to $28°$ ((002) plane), and the intensity I100 of the diffraction line around $2\theta = 41°$ ((100) plane), and (I002/I100), which was a ratio of the intensity 1002 of the diffraction line in the (002) plane to the intensity I100 of the diffraction line in the (100) plane, was considered as the orientation index.

$$\text{Orientation index} = (I002/I100)$$

(Examples 1 to 9, and Comparative Examples 1 to 9)

By using as a planetary centrifugal mixer, "Awatori Rentaro" manufactured by Thinky Corporation at rotating speed of 2000 rpm, six agglomerated powders of hexagonal boron nitride shown as thermally conductive powders in Table 1, five aluminum oxide powders, one ELASTOSIL LR3303/20/A solution (an organopolysiloxane having a vinyl group and containing a platinum catalyst) shown as the liquid silicone of addition reaction type in Tables 2 and 3, and one ELASTOSIL LR3303/20/B solution (an organopolysiloxane having a H-Si group, and an organopolysiloxane having a vinyl group) were mixed together in the blending ratio (% by volume) shown in Tables 2 and 3 at a room temperature for 10 minutes to produce a resin composition.

This resin composition in an amount of 100 g was loaded into a cylinder-structured metallic mold to which a die having a slit (thickness stated in Tables 2 and 3 $\times$ 100 mm, and thickness stated in Tables 2 and 3 $\times$ 10 mm) has been firmly installed in such a way that the thickness shown in the following Tables 2 and 3 was achieved, and subsequently, the resin composition was extruded from the slit under a pressure of 5 MPa by using a piston to obtain a green sheet of the resin composition. This green sheet was heated at 110°C for 3 hours to produce a sheet of the resin composition to be subjected to the evaluation of the thermal conductivity and the dielectric properties. The measurement results regarding the thermal conductivity and the dielectric constant of the sheet of the resin composition obtained in a way described above are shown in Tables 2 and 3.

50 cc of pure water and 5 g of a thermally conductive powder to be measured, which was each of the above powders as a sample for the evaluation of average particle size, were added to a glass beaker, stirred with a spatula, and subsequently, subjected to dispersing treatment for 10 minutes by using an ultrasonic washing machine. A solution of the powder of the thermally conductive material subjected to dispersing treatment was added dropwise to a sampler within the apparatus by using a pipette, and the stabilization of the absorbance was awaited until the absorbance was measurable. When the absorbance was stabilized in this way, the measurement was performed. According to the above-described method, the average particle size of each powder was determined.

From Examples in Table 2 and Comparative Examples in Table 3, it can be seen that the thermally conductive resin compositions of the present invention exhibit excellent thermal conductivity and low dielectric properties (dielectric constant).

[Table 1]

| Referential mark of filler | Type | Average particle size (μm) | Orientation index |
|---|---|---|---|
| Thermally conductive filler A | Agglomerated powder of hexagonal boron nitride | 100 | 14 |
| Thermally conductive filler B | Agglomerated powder of hexagonal boron nitride | 20 | 7 |
| Thermally conductive filler C | Agglomerated powder of hexagonal boron nitride | 15 | 6 |

(continued)

| Referential mark of filler | Type | Average particle size (μm) | Orientation index |
|---|---|---|---|
| Thermally conductive filler D | Agglomerated powder of hexagonal boron nitride | 10 | 6 |
| Thermally conductive filler E | Agglomerated powder of hexagonal boron nitride | 5 | 5 |
| Thermally conductive filler F | Aluminum oxide powder | 20 | - |
| Thermally conductive filler G | Aluminum oxide powder | 7 | - |
| Thermally conductive filler H | Aluminum oxide powder | 5 | - |
| Thermally conductive filler I | Aluminum oxide powder | 3 | - |
| Thermally conductive filler J | Aluminum oxide powder | 0.5 | - |
| Thermally conductive filler K | Agglomerated powder of hexagonal boron nitride | 40 | 10 |

[Table 2]

| | Example 1 | Example 2 | Example 3 | Example 4 | Example 5 | Example 6 | Example 7 | Example 8 | Example 9 | Example 10 |
|---|---|---|---|---|---|---|---|---|---|---|
| Type of boron nitride powder | B | c | D | c | c | c | c | c | c | B |
| Amount of boron nitride powder blended (% by volume) | 39 | 39 | 39 | 39 | 39 | 36 | 42 | 39 | 39 | 39 |
| Type of aluminum oxide powder | H | H | H | G | I | H | H | H | H | H |
| Amount of aluminum oxide powder blended (% by volume) | 26 | 26 | 26 | 26 | 26 | 24 | 28 | 26 | 26 | 26 |
| Amount of silicone resin LR3303/20/A blended (% by volume) | 17.5 | 17.5 | 17.5 | 17.5 | 17.5 | 20 | 15 | 17.5 | 17.5 | 17.5 |
| Amount of silicone resin LR3303/20/B blended (% by volume) | 17.5 | 17.5 | 17.5 | 17.5 | 17.5 | 20 | 15 | 17.5 | 17.5 | 17.5 |
| Presence or Absence of glass cloth | Absent | Absent | Absent | Absent | Absent | Absent | Absent | Absent | Absent | Present |
| Thermal conductivity (W/(m·K)) | 6.5 | 6.8 | 6.6 | 6.6 | 6.6 | 6.4 | 6.8 | 6.8 | 6.8 | 6.8 |
| Dielectric constant | 3.8 | 3.8 | 3.8 | 3.8 | 3.8 | 3.6 | 3.9 | 3.8 | 3.8 | 3.4 |
| Thickness (mm) | 0.2 | 0.2 | 0.2 | 0.2 | 0.2 | 0.2 | 0.2 | 0.1 | 0.5 | 0.2 |

[Table 3]

| | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|
| Type of boron nitride powder | A | E | C | C | C | C | C | C | K |
| Amount of boron nitride powder blended (% by volume) | 39 | 39 | 39 | 39 | 6 | 48 | 39 | 39 | 39 |
| Type of aluminum oxide powder | H | H | F | J | H | H | F | F | J |
| Amount of aluminum oxide powder blended (% by volume) | 26 | 26 | 26 | 26 | 4 | 32 | 26 | 26 | 26 |
| Amount of silicone resin LR3303/20/A blended (% by volume) | 17.5 | 17.5 | 17.5 | 17.5 | 45 | 10 | 17.5 | 17.5 | 17.5 |
| Amount of silicone resin LR3303/20/B blended (% by volume) | 17.5 | 17.5 | 17.5 | 17.5 | 45 | 10 | 17.5 | 17.5 | 17.5 |
| Presence or Absence of glass cloth | Absent | Absent | Absent | Absent | Absent | Absent | Absent | Absent | Absent |
| Thermal conductivity (W/(m·K)) | 5.8 | 4.8 | 4.4 | 4.5 | 1.2 | 3.7 | 1.2 | 1.4 | 3.6 |
| Dielectric constant | 3.8 | 3.8 | 3.8 | 3.8 | 3 | 4.2 | 3.8 | 3.8 | 3.8 |
| Thickness (mm) | 0.2 | 0.2 | 0.2 | 0.2 | 0.2 | 0.2 | 0.05 | 1 | 0.2 |

EP 3 667 718 B1

8

(Example 10)

100 g of resin composition of Example 1 was loaded into a cylinder-structured metallic mold to which a die having a slit (0.1 mm × 100 mm, and 0.1 mm × 10 mm) has been firmly installed, and the resin composition was extruded from the slit under a pressure of 5 MPa by using a piston to be molded into a green sheet of the resin composition, and subsequently, was subjected to a surface pressure of 15 MPa while being laminated on both faces of a glass cloth ("H25 F104" manufactured by Unitika Ltd.), and was heated at 150°C for 1 hour to produce a sheet having a thickness of 0.2 mm. This sheet had much better dielectric properties than that of the sheet of Example 1.

Industrial Applicability

When the heat-dissipating member according to an embodiment of the present invention is used in applications of electronic components, for example, when the heat-dissipating member is used as a heat-dissipating member in a heat-releasing semiconductor device such as a power device, a transistor, a thyristor, a CPU (Central Processing Unit) and the like, the devices may be used for a long period of time without being damaged.

## Claims

**1.** A heat-dissipating member in the form of a sheet having a thickness of 0.1 to 0.5 mm and comprising a resin composition, wherein

the resin composition contains

60 to 70% by volume of a thermally conductive filler including an agglomerated powder of hexagonal boron nitride having an average particle size of 10 to 20 $\mu$m and an orientation index defined below of 2 to 20, and an aluminum oxide powder having an average particle size of 3 to 7 $\mu$m, the average particle size and the orientation index are measured according to the description, and
30 to 40% by volume of a silicone resin,

wherein the orientation index is a ratio (I002/I100) of an intensity I002 of a diffraction line on a (002) plane to an intensity I100 of a diffraction line on a (100) plane according to X-ray powder diffraction, and
a blending ratio between the agglomerated powder of the hexagonal boron nitride and the aluminum oxide powder in the thermally conductive filler is in the range of 4:1 to 1:1 in terms of a volume ratio.

**2.** A heat-dissipating member, comprising the heat-dissipating member according to claim 1 laminated on a glass cloth.

## Patentansprüche

**1.** Wärmeableitungselement in Form eines Flächengebildes, das eine Dicke von 0,1 bis 0,5 mm aufweist und eine Harzzusammensetzung umfasst, wobei

die Harzzusammensetzung Folgendes enthält:

60 bis 70 Vol.-% eines wärmeleitenden Füllstoffs, der ein agglomeriertes Pulver aus hexagonalem Bornitrid mit einer durchschnittlichen Partikelgröße von 10 bis 20 $\mu$m und einem nachstehend definierten Orientierungsindex von 2 bis 20 und ein Aluminiumoxidpulver mit einer durchschnittlichen Partikelgröße von 3 bis 7 $\mu$m umfasst, wobei die durchschnittliche Partikelgröße und der Orientierungsindex gemäß der Beschreibung gemessen werden, und
30 bis 40 Vol.-% eines Silikonharzes,

wobei der Orientierungsindex ein Verhältnis (I002/I100) einer Intensität I002 einer Beugungslinie einer (002)-Ebene zu einer Intensität I100 einer Beugungslinie einer (100)-Ebene gemäß Pulver-Röntgenbeugung ist und
ein Mischungsverhältnis zwischen dem agglomerierten Pulver aus dem hexagonalen Bornitrid und dem Aluminiumoxidpulver in dem wärmeleitenden Füllstoff, als Volumenverhältnis angegeben, im Bereich von 4:1 bis 1:1 liegt.

**2.** Wärmeableitungselement, welches das auf ein Glastuch laminierte Wärmeableitungselement nach Anspruch 1 umfasst.

**Revendications**

**1.** Élément de dissipation de chaleur sous la forme d'une feuille ayant une épaisseur de 0,1 à 0,5 mm et comprenant une composition de résine, où

la composition de résine contient

60 à 70 % en volume d'une charge thermoconductrice comprenant une poudre agglomérée de nitrure de bore hexagonal ayant une taille moyenne de particule de 10 à 20 $\mu$m et un indice d'orientation défini ci-dessous de 2 à 20, et une poudre d'oxyde d'aluminium ayant une taille moyenne de particule de 3 à 7 $\mu$m, la taille moyenne de particule et l'indice d'orientation étant mesurés selon la description, et
30 à 40 % en volume d'une résine de silicone,

où l'indice d'orientation est un rapport (I002/I100) d'une intensité I002 d'une ligne de diffraction sur un plan (002) à une intensité I100 d'une ligne de diffraction sur un plan (100) selon la diffraction des rayons X sur poudre, et
un rapport de mélange entre la poudre agglomérée du nitrure de bore hexagonal et la poudre d'oxyde d'aluminium dans la charge thermoconductrice situé dans une plage de 4:1 à 1:1 en termes de rapport volumique.

**2.** Élément de dissipation de chaleur, comprenant l'élément de dissipation de chaleur selon la revendication 1 feuilleté sur une toile de verre.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11060216 A
- JP 2003060134 A
- JP 2008293911 A
- JP 2009024126 A
- JP 9202663 A
- JP 11026661 A
- JP 2011144234 A
- JP 2014172768 A